Europäisches Patentamt

European Patent Office

Office européen des brevets

(19)

(11) **EP 1 338 897 A2**

(12) **DEMANDE DE BREVET EUROPEEN**

(43) Date de publication:
**27.08.2003  Bulletin 2003/35**

(51) Int Cl.⁷: $G01R\ 21/133$

(21) Numéro de dépôt: **03366001.0**

(22) Date de dépôt: **13.02.2003**

(84) Etats contractants désignés:
**AT BE BG CH CY CZ DE DK EE ES FI FR GB GR
HU IE IT LI LU MC NL PT SE SI SK TR**
Etats d'extension désignés:
**AL LT LV MK RO**

(30) Priorité:  **15.02.2002  FR 0201884**

(71) Demandeur: **STMicroelectronics S.A.
92120 Montrouge (FR)**

(72) Inventeur: **Le Van Suu, Maurice
57070 Metz (FR)**

(74) Mandataire: **Bentz, Jean-Paul
Cabinet Ballot
9, rue Claude Chappe
Metz Technopôle
57070 Metz (FR)**

(54) **Compteur électrique**

(57)     L'invention concerne un compteur électrique pour mesurer la puissance consommée sur une ligne électrique. Le compteur comprend un mesureur de courant (110) pour produire un courant image (II(t)) du courant instantané (I(t)) circulant dans la ligne, et un mesureur de tension pour (120) produire une tension image (VT(t)) de la tension instantanée (U(t)) circulant dans la ligne.

Selon l'invention, le compteur comprend également :

- un premier générateur (130) de tension pour produire une tension de référence (VREF) triangulaire de période T,
- un circuit de calcul (140) d'une puissance image (IP(t)) de la puissance instantanée consommée sur la ligne, à partir du premier courant image (II(t)), de la tension image (VT(t)) et de la tension de référence (VREF),
- un convertisseur (150) pour produire un signal numérique de puissance (PC) représentatif de la puissance image (IP(t)).

Fig. 1

Printed by Jouve, 75001 PARIS (FR)

## Description

L'invention concerne un compteur électrique, destiné à mesurer la puissance électrique transitant en un point d'une ligne électrique. L'invention est notamment intéressante pour la réalisation de compteurs électriques domestiques ou industriels. Ces compteurs sont utilisés notamment par les fournisseurs d'énergie électrique, pour mesurer la consommation de leurs clients.

La complexité des compteurs électriques dépend notamment de la ligne électrique et de l'énergie électrique fournie : mono / triphasée, importance du courant consommé, etc.

Les premiers compteurs électriques étaient des compteurs mécaniques, relativement peu onéreux. Les premiers compteurs numériques apparaissent vers 1987. Plus chers certes que les compteurs mécaniques, ils présentent cependant l'avantage de pouvoir être pilotés à distance, et de disposer d'un nombre de fonctionnalités beaucoup plus important qu'un compteur mécanique (ex: changement de tarification, changement de calibre, etc.).

De manière connue, un compteur électrique numérique comprend un mesureur de courant, un mesureur de tension, un convertisseur A/D analogique / numérique et un microprocesseur. Les mesureurs de courant et de tension sont par exemple réalisés à partir de transformateurs d'intensité, de résistances shunt ou de sonde à effet Hall. Ils mesurent le courant circulant dans la ligne électrique et la tension appliquée. Plusieurs mesureurs de courant peuvent être prévus, pour pouvoir mesurer avec le même compteur électrique, des courants de calibres différents. Le convertisseur A/D reçoit les signaux produits par les mesureurs de courant et de tension, les numérise et fournit deux nombres binaires représentatifs pour l'un de la tension appliquée et pour l'autre du courant circulant dans la ligne électrique. Le microprocesseur calcule ensuite le produit des deux nombres, le résultat étant représentatif de la puissance consommée sur la ligne.

De tels compteurs électriques sont assez aisés à mettre en oeuvre dans le cas d'une ligne électrique monophasée. Ils deviennent cependant beaucoup plus complexes et onéreux pour une ligne triphasée. Dans ce cas en effet, le nombre de mesureurs courant / tension doit être multiplié par trois, et surtout un microprocesseur beaucoup plus performant doit être utilisé pour calculer ensuite la puissance consommée. Une augmentation de la taille du microprocesseur entraîne bien sûr une augmentation proportionnelle du coût du compteur utilisant un tel microprocesseur.

Au vu des inconvénients des compteurs électriques numériques existants, l'invention a pour but de réaliser un compteur électrique numérique beaucoup plus simple que les compteurs existants.

Un autre but de l'invention est de réaliser un compteur électrique ayant des performances au moins équivalentes à celles des compteurs connus.

Un autre but enfin est de réaliser un compteur électrique moins cher que les compteurs équivalents existants.

Pour atteindre ces buts, l'invention réalise un compteur électrique pour mesurer la puissance consommée sur une ligne électrique. Le compteur comprend un mesureur de courant pour produire un courant image du courant instantané circulant dans la ligne, et un mesureur de tension pour produire une tension image de la tension instantanée circulant dans la ligne.

Selon l'invention, le compteur comprend également :

- un premier générateur de tension pour produire une tension de référence triangulaire de période T,
- un circuit de calcul d'une puissance image de la puissance instantanée consommée sur la ligne, à partir du premier courant image, de la tension image et de la tension de référence,
- un convertisseur pour produire un signal numérique de puissance représentatif de la puissance image.

Ainsi, un compteur selon l'invention n'utilise pas de microprocesseur pour le calcul de la puissance consommée, ce qui supprime tous les inconvénients liés à la présence d'un tel microprocesseur.

Dans l'invention, le microprocesseur habituellement utilisé pour le calcul de la puissance est remplacé par un circuit de calcul analogique, réalisant un calcul similaire. Un tel circuit de calcul analogique présente les avantages d'être performant, facile à mettre en oeuvre, et beaucoup moins cher qu'un microprocesseur.

De préférence, le premier générateur de tension comprend des moyens pour ajuster la période de la tension de référence de sorte à ajuster un calibre de puissance du compteur en fonction de l'amplitude du courant instantané circulant dans la ligne. Ainsi, et contrairement à un compteur selon l'art antérieur, on utilise un seul mesureur de courant et un seul mesureur de tension, quel que soit le calibre de la puissance à mesurer.

Le circuit de calcul utilisé pour mettre en oeuvre l'invention comprend de préférence :

- un circuit d'entrée pour produire un courant moyen représentatif de la valeur moyenne du courant image,
- un circuit d'adaptation pour produire un signal en créneaux de période T, actif pendant une durée T0 proportionnelle au courant moyen, et d'amplitude, lorsqu'il est actif, proportionnelle à la tension image,
- un premier intégrateur, pour intégrer le signal en créneaux et produire la puissance image.

Avec le compteur selon l'invention, on calcule d'abord un courant moyen consommé. On synchronise ensuite la tension image et le courant moyen sur la tension de référence à l'aide du circuit d'adaptation. Ceci est nécessaire pour effectuer un calcul exact de la puissance instantanée. Le signal en créneaux obtenu ainsi est représentatif du produit de la tension instantanée par le courant instantané consommé comme on le verra mieux par la suite ; le signal en créneaux est ainsi représentatif de la puissance instantanée consommée sur la ligne.

Le circuit d'entrée comprend de préférence un deuxième intégrateur pour intégrer le courant image reçu sur une première entrée et produire le courant moyen sur une sortie, et un circuit de calibrage, pour adapter un niveau d'entrée de l'intégrateur en fonction du courant moyen.

Le circuit de calibrage a pour but essentiel d'adapter le niveau d'entrée du deuxième intégrateur en fonction du courant moyen : on évite ainsi de saturer les composants du deuxième intégrateur (et plus généralement de tous les composants en aval) ; ceci élimine tout risque d'erreur dan le calcul de la puissance instantanée consommée.

Le circuit de calibrage comprend par exemple :

- un troisième intégrateur comprenant une entrée connectée à la sortie du deuxième intégrateur, et
- un pont diviseur de tension dont une entrée est connectée à une sortie du troisième intégrateur et dont une sortie est connectée à une deuxième entrée du deuxième intégrateur.

Le deuxième intégrateur comprend par exemple :

- un premier amplificateur opérationnel comprenant une entrée positive connectée à une masse, et une sortie connectée à une sortie du deuxième intégrateur sur laquelle est disponible le courant moyen, et
- un premier condensateur connecté entre une entrée négative et la sortie du premier amplificateur, l'entrée négative du premier amplificateur étant également connectée à la deuxième entrée du deuxième intégrateur.

Selon un mode de réalisation, le deuxième intégrateur comprend également une première résistance connectée entre une entrée négative du premier amplificateur et la première entrée de l'intégrateur.

Selon un autre mode de réalisation, le deuxième intégrateur comprend également une capacité commutée, en complément du premier amplificateur opérationnel et du premier condensateur. La capacité commutée a deux pôles et comprend :

- un premier interrupteur et un deuxième interrupteur connectés en série entre les deux pôles de la capacité commutée, le premier interrupteur et le deuxième interrupteur étant commandés par des signaux d'horloge en opposition de phase,
- un deuxième condensateur connecté entre la masse et un point commun du premier interrupteur et du deuxième interrupteur.

Le circuit d'adaptation comprend par exemple :

- un comparateur comprenant une entrée positive sur laquelle est appliquée la tension de référence et une entrée négative sur laquelle est appliquée le courant moyen, le comparateur produisant un signal de commande,
- une deuxième résistance et un troisième interrupteur connectés en série entre une entrée et une sortie du circuit d'adaptation sur laquelle est produit le signal en créneaux, le troisième interrupteur étant commandé par le signal de commande, la tension image étant appliquée à l'entrée du circuit d'adaptation.

Enfin, le convertisseur courant / fréquence comprend :

- un deuxième générateur de tension recevant la puissance image et produisant, en fonction du signal numérique, une tension triangulaire qui est :

- croissante selon une pente proportionnelle à +IP, si le signal numérique de puissance est actif, IP étant la puissance image, ou
- décroissante selon une pente proportionnelle à -IP si le signal numérique de puissance est inactif,
- une bascule pour produire le signal numérique qui est :

- actif lorsque la tension triangulaire est croissante et inférieure à un premier seuil, et
- inactif lorsque la tension triangulaire est décroissante et supérieure à un deuxième seuil,

la fréquence du signal numérique de puissance étant représentative de la puissance instantanée consommée.

Le compteur selon l'invention décrit ci-dessus peut être utilisé pour mesurer la puissance électrique consommée sur une ligne monophasée.

Dans le cas où il est envisagé de mesurer la puissance consommée sur une ligne polyphasée, le compteur ci-dessus sera avantageusement complété par un mesureur de courant et un mesureur de tension pour chaque phase. Par ailleurs, le circuit de calcul est complété par un circuit d'entrée et un circuit d'adaptation pour chaque phase et on connecte la sortie de chaque circuit d'adaptation à l'entrée du circuit d'intégration. Le signal en créneau résultant présent sur l'entrée du premier intégrateur est dans ce cas représentatif de la somme des puissances consommées sur chaque phase.

L'invention et les avantages qui en découlent apparaîtront plus clairement à la lecture de la description qui suit d'exemples de réalisation d'un compteur électrique, selon l'invention. La description est à lire en référence aux dessins annexés dans lesquels :

- La figure 1 est un schéma de principe d'un compteur électrique selon l'invention,
- les figures 2 à 5 détaillent des modes de réalisation d'éléments du compteur de la figure 1,
- la figure 6 est un chronogramme montrant en fonction du temps l'évolution de signaux en différents points du compteur de la figure 1,
- les figures 7a, 7b détaillent un autre mode de réalisation d'éléments du compteur de la figure 1.

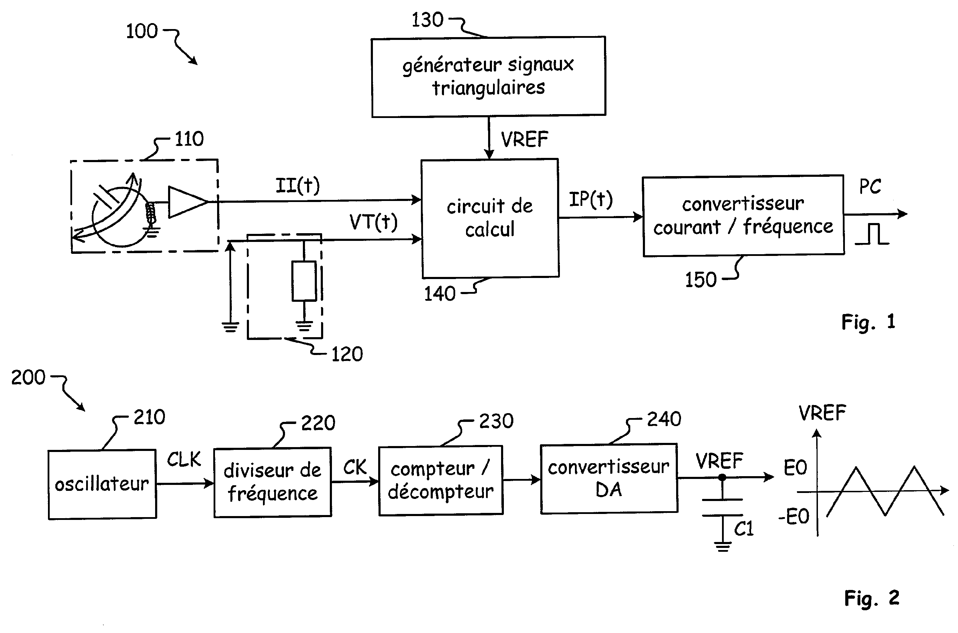

Un compteur électrique 100 selon l'invention est représenté schématiquement sur la figure 1. Il comprend un mesureur de courant 110, un mesureur de tension 120, un générateur 130 de signaux triangulaires, un circuit 140 de calcul de puissance instantanée, et un convertisseur 150 courant / fréquence.

Le mesureur de courant 110 est réalisé selon un schéma connu, il utilise par exemple une résistance shunt ou une sonde à effet Hall, et un amplificateur. Il produit un courant II(t), image du courant I(t) instantané circulant dans une ligne électrique (non représentée figure 1) dont on souhaite mesurer la puissance consommée .

Le mesureur de tension 120 est également réalisé selon un schéma connu, il utilise par exemple un pont diviseur de tension. Il produit une tension VT(t), image de la tension U(t) présente sur la ligne étudiée.

Le générateur 130 produit une tension triangulaire de référence VREF, variant entre - E0 et + E0, et de période T fixée.

Le circuit de calcul 140 calcule la puissance instantanée consommée sur la ligne étudiée, à partir du courant II(t), de la tension VT(t) et de la tension VREF. Le circuit 140 produit un résultat sous la forme d'un courant IP(t), image de la puissance instantanée consommée.

Enfin, le convertisseur 150 transforme le courant IP(t) en un signal PC impulsionnel, dont la fréquence est proportionnelle à l'amplitude du courant IP(t), c'est-à-dire dont la fréquence est proportionnelle à la puissance consommée sur la ligne électrique étudiée.

La figure 2 détaille un mode de réalisation du générateur 130, sous la forme d'un circuit 200 numérique comprenant un oscillateur 210, un diviseur de fréquence 220, un compteur 230 numérique, un convertisseur 240 digital / analogique, un condensateur 250.

L'oscillateur 210 produit un signal d'horloge CLK périodique, de période constante. L'oscillateur 210 est par exemple un oscillateur à quartz, apte à fournir un signal parfaitement stable en fréquence. Le diviseur 220 produit un signal d'horloge CK dont la fréquence est égale à la fréquence du signal CLK divisée par N1. De préférence, le diviseur 220 comprend des moyens pour varier le nombre N1.

L'oscillateur 210 et le diviseur de fréquence 220 forment ainsi ensemble un générateur de signaux d'horloge de fréquence variable, particulièrement stable.

Le compteur 230 numérique est cadencé par le signal CK, il produit des nombres signés compris entre - N2 + 1 et +N2. Dans un exemple, N2 = 128. Le compteur 230 est un compteur / décompteur : à chaque impulsion du signal CK, il est incrémenté depuis - 127 jusqu'à + 128 (pour N2 = 128) puis décrémenté depuis + 128 jusqu'à - 127, au cours d'une période du compteur / décompteur.

Le convertisseur 240 est un convertisseur digital analogique, il produit une tension constante sur une période du signal CK et dont l'amplitude est proportionnelle au nombre produit par le compteur 230. Le convertisseur 240 produit ainsi une tension périodique (de période égale à 2*N2 fois la période du signal CK) en forme d'escalier montant ou descendant selon le sens de variation des nombres produits par le compteur 230, et variant entre - E0 et + E0.

La tension produite par le convertisseur 240 est ensuite intégrée par le condensateur 250, qui produit sur une sortie une tension triangulaire VREF, variant entre - E0 et + E0 et de période égale à T. La stabilité en fréquence de la tension VREF produite dépend directement de la stabilité du signal CLK produit par l'oscillateur 210. La période de la tension de référence VREF dépend de la période du signal CLK, du nombre N1 utilisé par le diviseur de fréquence 220 et du nombre N2 associé au compteur / décompteur 230. Si TC est la période du signal CLK, alors T = TC / (N1*2N2).

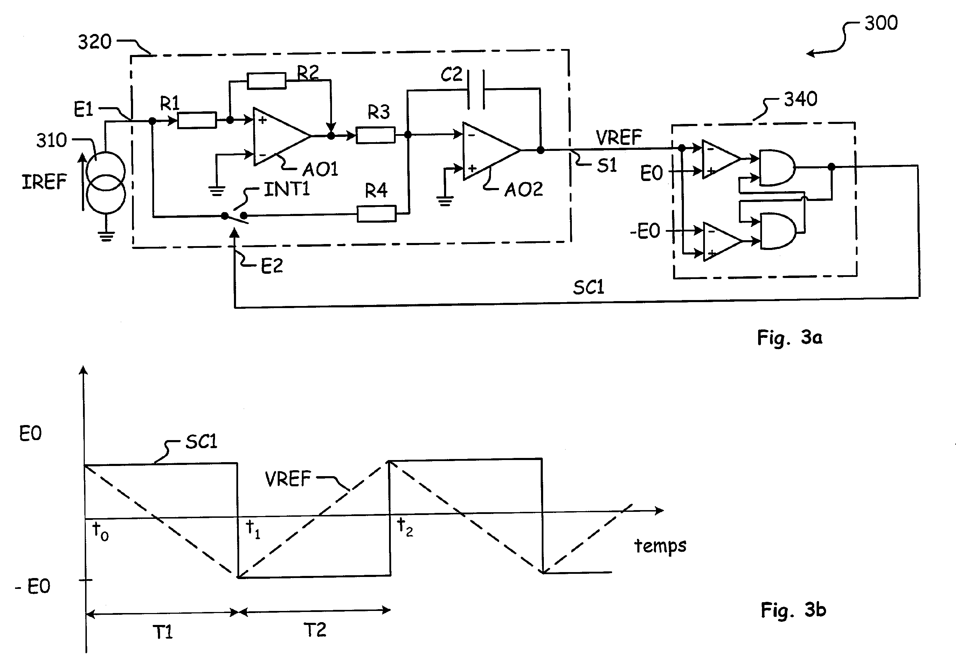

La figure 3 détaille un autre mode de réalisation du générateur 130, sous la forme d'un circuit 300 analogique comprenant une source de courant 310, un générateur de tension 320 et une bascule RS 340.

La source de courant 310 produit un courant IREF constant dans le temps. De préférence, la source 310 est choisie aussi stable que possible. De préférence encore, la source 310 comprend des moyens pour modifier la valeur du courant IREF.

Le circuit 320 reçoit le courant IREF sur une entrée E1, et produit la tension VREF qui est proportionnelle à + IREF ou - IREF selon un signal de commande SC1 reçu sur une entrée de commande E2. VREF a les caractéristiques suivantes :

- VREF augmente selon la pente +K*IREF si SC1 est actif,
- VREF diminue selon la pente -K*IREF si SC1 est inactif.

Le circuit 320 comprend dans un exemple (figure 3) deux amplificateurs opérationnels AO1 AO2, quatre résistances R1, R2, R3, R4, un condensateur C2 et un interrupteur INT1. La constante K est fonction de la valeur des résistances R1, R2, R3, R4 et de la valeur de la capacité du condensateur C2.

La résistance R1 est connectée entre l'entrée E1 du circuit 320 et une entrée positive de l'amplificateur AO1 dont une entrée négative est reliée à la masse. la résistance R2 est connectée entre l'entrée positive et une sortie de l'amplificateur AO1 L'amplificateur AO1 et les résistances R1, R2 forment ainsi ensemble un montage suiveur (adaptateur d'impédance) qui peut éventuellement être supprimé.

La résistance R2 est connectée entre la sortie de l'amplificateur AO1 et une entrée négative de l'amplificateur AO2 dont une entrée positive est connectée à la masse. La résistance R4 et l'interrupteur INT1 sont connectés en série entre l'entrée E1 du circuit 320 et l'entrée négative de l'amplificateur AO2. L'interrupteur INT1 est ouvert si le signal SC1 est inactif et il est fermé si le signal INT1 est actif. Le condensateur C2 est connecté entre l'entrée négative et la sortie de l'amplificateur AO2.

Enfin, la sortie de l'amplificateur AO2 est connectée à la sortie S1 du circuit 320 sur laquelle est disponible la tension VREF.

La bascule 340 est de type RS, comprenant une entrée connectée à la borne S1 du circuit 320 sur laquelle est produite la tension de référence VREF. La bascule 340 comprend également deux entrées de référence sur lesquelles sont appliqués des potentiels + E0 et - E0. La bascule 340 produit le signal SC1 qui est :

- actif si la tension de référence VREF augmente et est inférieure à + E0,
- inactif si la tension VREF diminue et est supérieure à - E0.

La bascule RS est réalisée selon un schéma connu (figure 3), qui comprend deux comparateurs, pour comparer la tension VREF avec les potentiels de référence -E0 et +E0, et deux portes logiques de type NON-OU. Le signal SC1 est produit sur une sortie de l'une des portes logiques.

Le circuit 300 fonctionne de la manière suivante. On suppose qu'initialement, le condensateur C2 est déchargé, la tension VREF est alors égale à + E0. La bascule 340 produit un signal SC1 = 0 (inactif) et l'interrupteur INT1 s'ouvre.

Le courant IREF circule dans les résistances R1, R2, R3 et charge le condensateur C2 : la tension VREF diminue, selon une pente égale à - IREF/(Req1*C2). Req1 est la résistance équivalente d'entrée de l'amplificateur AO2 lorsque INT1 est ouvert. Req1 dépend notamment des résistances R1, R2, R3 et des caractéristiques de l'amplificateur AO1.

A l'instant t1, la tension VREF atteint - E0, la bascule 340 fournit alors un signal SC1 actif (égal à 1), l'interrupteur INT1 se ferme et le condensateur C2 se décharge. La tension VREF augmente selon une pente constante égale à + IREF/(Req2*C2). Req2 est la résistance équivalente d'entrée de l'amplificateur AO2 lorsque INT1 est fermé. Reg2 dépend notamment des résistances R1, R2, R3, R4 et des caractéristiques de l'amplificateur AO1.

Lorsque la tension VREF atteint + E0 (à l'instant t2), le circuit 340 bascule à nouveau et le signal SC1 devient inactif (égal à 0) : le condensateur C2 se charge à nouveau.

Les résistances R1, R2, R3, R4 sont choisies de sorte que les résistances équivalentes Req1 (INT1 ouvert) et Req2 (INT1 fermé) soient égales, et de sorte que la tension VREF varie entre -E0 et +E0.

On obtient ainsi une tension VREF qui est triangulaire avec un rapport cyclique égal à ½. La période du signal VREF est ici égale à :

$$T = 4*E0*Req1*C2/IREF$$

T est fonction de la valeur des résistances R1, R2, R3, R4 et de la capacité du condensateur C2 : ces éléments sont constants. T est également inversement proportionnelle à IREF. Il est ainsi possible de modifier la période T de la tension VREF en modifiant simplement le courant IREF.

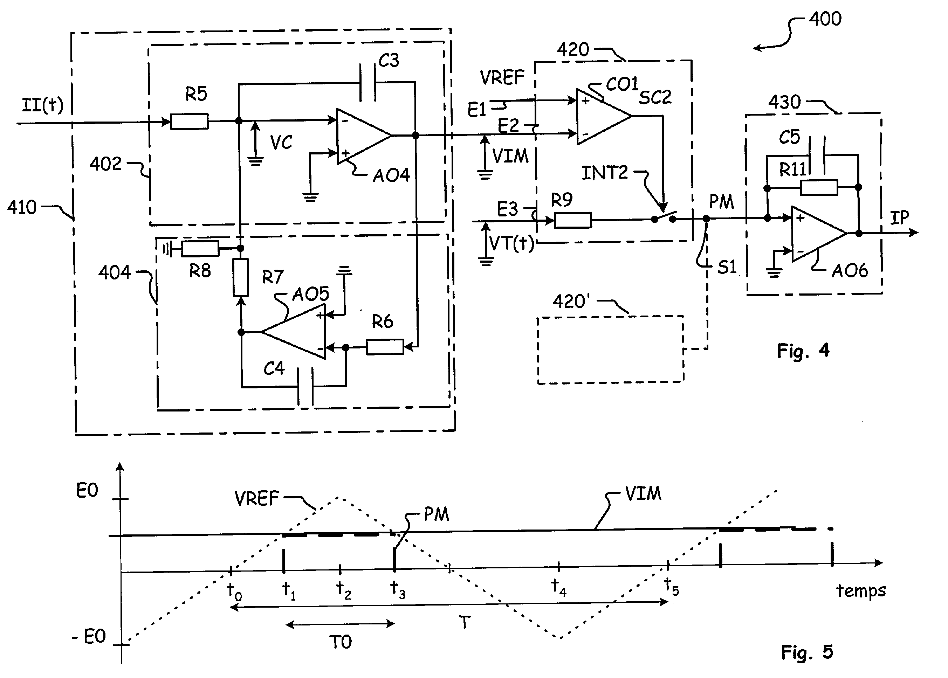

La figure 4 détaille un mode de réalisation du circuit 140 de calcul de la puissance instantanée consommée sur la ligne électrique étudiée, sous la forme d'un circuit 400 analogique comprenant un circuit d'entrée 410, un circuit d'adaptation 420 et un intégrateur 430.

Le circuit 410 reçoit le courant II(t) produit par le mesureur de courant 110 et produit une tension VIM, qui est une image de la valeur moyenne du courant II(t) et donc du courant I(t) circulant sur la ligne électrique étudiée.

Le circuit 420 reçoit la tension de référence VREF produite par le générateur 130, la tension VIM et la tension VT(t) produite par le mesureur de tension 120, respectivement sur trois entrées E1, E2, E3. Le circuit 420 produit, sur une sortie S1, un signal PM en créneaux représentatif de la puissance consommée sur la ligne étudiée.

Le circuit 430 intègre le signal PM et produit le courant IP(t), représentatif de la puissance instantanée consommée sur la ligne étudiée.

Le circuit 410 d'entrée comprend (figure 4) un intégrateur 402 et un circuit 404 de calibrage.

L'intégrateur 402 a pour but d'intégrer le courant II(t) produit par le mesureur de courant 110. Il produit la tension VIM, image de la valeur moyenne du courant II(t) et donc du courant I(t) consommé sur la ligne étudiée.

L'intégrateur 402 comprend une résistance R5, un condensateur C3 et un amplificateur opérationnel AO4. La résistance R5 est connectée d'une part à une entrée de l'intégrateur 402 sur laquelle est appliqué le courant II(t) et d'autre part à une entrée négative de l'amplificateur AO4 dont une entrée positive est connectée à la masse. Le condensateur C3 est connecté entre l'entrée négative et une sortie de l'amplificateur AO4. La sortie de AO4 forme la sortie de l'intégrateur 402 et la sortie du circuit d'entrée 410. L'intégrateur 402 a une constante de temps égale à RE*C3. RE est la résistance équivalente d'entrée de l'intégrateur 402. On en déduit la valeur de la tension VIM :

$$VIM = K1 * <I(t)>, \text{ avec}$$

<I(t)> la valeur moyenne du courant consommé dans la ligne étudiée et K1, une constante qui dépend notamment du mesureur de courant et de la constante de temps RE*C3 de l'intégrateur 402.

Le circuit de calibrage 404 a pour but d'adapter la résistance équivalente RE de l'intégrateur 402 pour adapter le niveau de tension sur l'entrée négative de l'amplificateur AO4 et le niveau du courant circulant dans le condensateur C3 en fonction de la valeur moyenne du courant consommé (dont la tension VIM est une image). Dit autrement, le circuit 404 permet de calibrer le circuit d'entrée en fonction du courant consommé. Ceci permet notamment de ne pas saturer l'ensemble des amplificateurs du compteur électrique de l'invention et d'effectuer des mesures correctes et précises de la puissance consommée, quelle que soit la valeur de cette puissance. Grâce à la présence du circuit 404, le compteur selon l'invention peut être utilisé pour une large gamme de courants et donc de puissances consommées (notion de calibrage d'un compteur électrique).

Le circuit 404 de calibrage comprend dans l'exemple de la figure 4 un amplificateur AO5, un condensateur C4, trois résistances R6, R7, R8. La résistance R6 est connectée d'une part à la sortie de l'amplificateur AO4 et d'autre part à une entrée négative de l'amplificateur AO5 dont une entrée positive est connectée à la masse. Le condensateur C4 a un pôle connecté à l'entrée négative de l'amplificateur AO5 et un autre pôle connecté à la sortie de AO5. La résistance R7 est connectée entre la sortie de l'amplificateur AO5 et l'entrée négative de l'amplificateur AO4. La résistance R8 est connectée entre l'entrée négative de AO4 et la masse.

L'amplificateur AO5, la résistance R6 et le condensateur C4 forment un intégrateur de constante de temps égale à R6*C4, utilisé pour intégrer la tension VIM. Les résistances R7, R8 forment quant à elles un pont diviseur de tension produisant une tension VC qui est une fraction de la tension produite par l'amplificateur AO5. La tension VC est appliquée sur l'entrée négative de l'amplificateur AO4 pour adapter son niveau d'entrée.

Le circuit d'adaptation 420 comprend un comparateur CO1, une résistance R9 et un interrupteur INT2.

Le comparateur CO1 comprend une entrée positive et une entrée négative connectées respectivement aux entrées E1 et E2 du circuit 420, pour recevoir respectivement la tension VREF et la tension VIM. Le comparateur produit le signal SC2, résultat de la comparaison de la tension VIM avec la tension de référence VREF. Le signal SC2 est appliqué sur une borne de commande de l'interrupteur INT2 dont une borne de sortie est connectée à la sortie S1 du circuit 420.

Le comparateur CO1 peut être réalisé indifféremment selon un schéma analogique ou un schéma numérique ; de tels modes de réalisation sont connus par ailleurs.

La résistance R9 est connectée entre une borne d'entrée de l'interrupteur INT2 et l'entrée E3 du circuit 420 sur laquelle est appliquée la tension VT(t). La résistance R9 forme en pratique un générateur de courant qui produit un courant proportionnel à la tension appliquée sur la ligne étudiée.

Le fonctionnement du circuit d'adaptation 420 est décrit ci-dessous en relation avec la figure 5, qui est un chronogramme montrant en fonction du temps l'évolution de signaux en différents points du circuit 420.

Sur la figure 5 est représentée en trait plein la tension VIM : elle est constante à l'échelle d'une période de la tension VREF. Dans l'exemple de la figure 5, la tension VIM est légèrement supérieure à E0/2.

La tension de référence VREF triangulaire est représentée en pointillés. Enfin, le signal de commande PM2 est représenté en tirets épais (signal en créneaux). Le signal SC2 (non représenté sur la figure 5) est inactif lorsque le signal PM n'est pas défini, et il est actif lorsque le signal PM est égal VIM. Les échelles, notamment en ordonnées ne sont pas respectées par souci de clarté.

On suppose qu'initialement, à l'instant t0, la tension VREF est égale à zéro et est dans une phase de croissance, selon la pente 4*E0/T, T étant la période du signal VREF.

A t0, la tension VIM est supérieure à la tension VREF et le comparateur CO1 produit le signal SC2 inactif : l'interrupteur INT2 est ouvert et le signal PM est non défini. La tension VREF continue à croître.

A l'instant t1, la tension VREF atteint la valeur de VIM. Le comparateur CO1 produit alors le signal SC2 actif : l'interrupteur INT2 se ferme, le signal PM est proportionnel au courant circulant dans la résistance R9 et donc à la tension U(t) appliquée sur la ligne étudiée.

A l'instant t2, la tension VREF atteint la valeur E0 puis décroît selon la pente - 4*E0/T.

A l'instant t3, la tension VREF est égale à VIM : le signal SC2 devient inactif et l'interrupteur INT2 s'ouvre, le signal PM n'est plus défini.

A l'instant t4, la tension VREF atteint la valeur - E0 puis croît selon la pente 4*E0 / T.

A l'instant t5, la tension VREF passe à zéro puis continue à croître.

Le tout se répète ensuite au cours de cycles de durée T.

La période de la tension VREF (et donc celle du signal PM) est égale à T = t5 - t0.

Au cours d'une période T, le temps T0 pendant lequel le signal SC2 est actif (et le signal PM défini égal à VIM) est égal à T0 = T*(E0 - VIM) / (2*E0).

La valeur de T0 est calculée à partir des éléments suivants (t = temps) :

- entre 0 et t2, on a : VREF = 4*E0*t / T - E0
- VREF = VIM pour t = t1 et VREF = E0 pour t = t2
- T0 = 2*(t2 - t1)

On définit, pour le signal PM, un rapport cyclique RC par RC = T0 / T soit RC = (E0 - VIM) / (2*E0).

RC est égal à 1/2 lorsque VIM = 0 et RC est égal à 0 lorsque VIM = E0. RC est inversement proportionnel à la tension VIM. Dit autrement, RC est inversement proportionnel au courant moyen <I(t)> consommé dans la ligne étudiée.

T0 est également la durée pendant laquelle le signal PM est défini au cours d'une période T du signal VREF. Lorsqu'il existe, le signal PM a une valeur proportionnelle à la tension U(t) sur la ligne étudiée. On en déduit finalement que le signal PM est représentatif de la puissance instantanée consommée sur la ligne étudiée.

On notera qu'un des intérêts du circuit d'adaptation 420 utilisé ici est de synchroniser les signaux VIM (et donc indirectement le courant II(t) mesuré) et la tension VT(t) ensemble sur le signal de référence VREF. Ceci est indispensable pour réaliser ensuite de manière exacte le produit de ces signaux (via l'interrupteur INT2).

L'intégrateur 430 intègre le signal PM et produit ainsi le courant IP, image de la puissance instantanée consommée sur la ligne étudiée.

L'intégrateur 430 comprend (dans l'exemple de la figure 4) un amplificateur opérationnel AO6, une résistance R11 et un condensateur C5. La résistance R11 et le condensateur C5 sont connectés en parallèle entre une entrée positive et une sortie de l'amplificateur AO6 dont une entrée négative est reliée à la masse. Enfin, l'entrée positive de AO6 est connectée à la sortie S1 du circuit 420 pour recevoir le signal PM et la sortie de AO6 est connectée à une sortie de l'intégrateur 430 sur laquelle le courant IP est disponible.

Le courant IP est égal à la valeur du signal PM actif multipliée par la durée du signal PM actif et divisée par la période du signal PM, soit :

$$IP = K3 * U * (E0-VIM)/(2*E0)$$

où K3 est une constante dépendant des éléments R11, C5, AO6 de l'intégrateur 430 et de la résistance R9 du circuit d'adaptation 420.

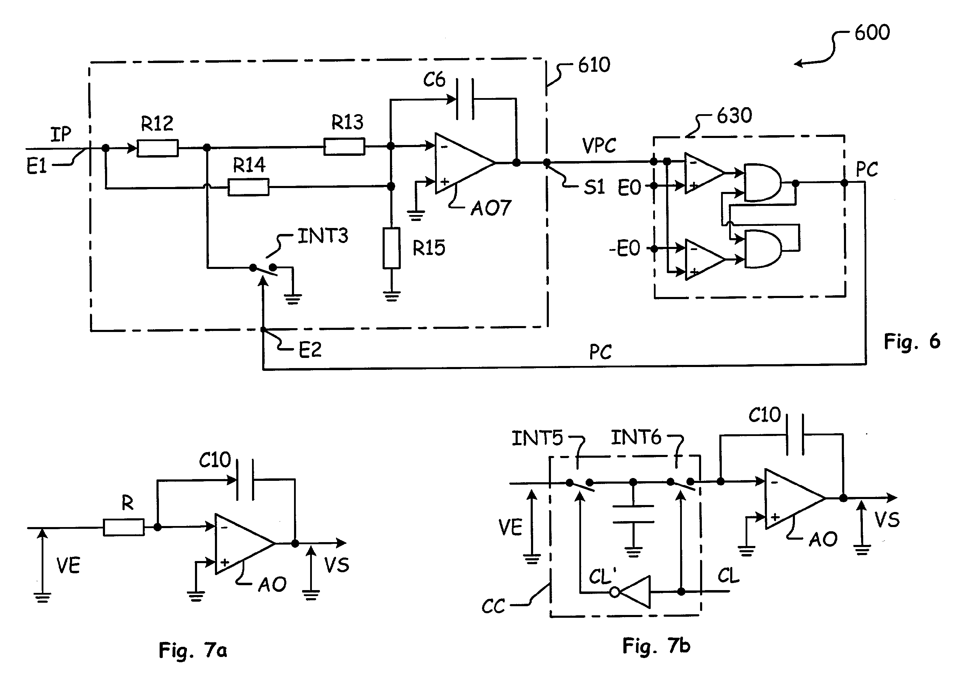

La figure 6 détaille un mode de réalisation du convertisseur 150 tension / fréquence, sous la forme d'un circuit 600 analogique comprenant un générateur de tension 610 et une bascule RS 630. En pratique, le convertisseur 600 de la figure 6 est assez proche du générateur de signaux triangulaires selon la figure 3.

Le générateur 610 reçoit le courant IP produit par le circuit 140 de calcul de la puissance instantanée sur une entrée E1, et produit une tension VPC qui est proportionnelle à + IP ou - IP selon un signal de commande PC reçu sur une entrée de commande E2. VPC a les caractéristiques suivantes :

- VPC augmente selon la pente +K4*IP si PC est actif,
- VPC diminue selon la pente -K5*IP si PC est inactif.

K4, K5 sont des constantes de temps.

L'amplitude du courant IP est quasi - constante sur une période T de la tension de référence VREF, car la période T est très brève par rapport à la variation de la puissance consommée sur la ligne étudiée.

Dans l'exemple de la figure 6, le circuit 610 comprend quatre résistances R12, R13, R14, R15, un condensateur C6, un amplificateur opérationnel AO7, et un interrupteur INT3 commandé par le signal PC.

Les résistances R12, R13 sont connectées en série entre une entrée E1 du circuit 610 sur laquelle est appliqué le courant IP et une entrée négative de l'amplificateur AO7 dont une entrée positive est connectée à la masse. Les résistances R14, R15 sont connectées en série entre l'entrée E1 du circuit 610 et une masse du circuit, le point commun des résistances R14, R15 étant connecté à l'entrée négative de l'amplificateur AO7. Le condensateur C6 est connecté entre l'entrée négative et la sortie de l'amplificateur AO7 qui est connectée à la sortie S1 du circuit 610.

La bascule 630 est de type RS, comprenant une entrée connectée à la borne S1 du circuit 610 sur laquelle est produite la tension VPC. La bascule 630 comprend également deux entrées de référence sur lesquelles sont appliquées des potentiels + E0 et - E0. La bascule 630 produit le signal PC qui est :

- actif (égal à 1) si la tension VPC augmente et est inférieure à + E0,
- inactif si la tension VPC diminue et est supérieure à - E0.

Le signal PC est utilisé pour commander l'interrupteur INT3, qui est fermé lorsque PC est actif, et qui est ouvert si PC est inactif.

Lorsque PC est actif, INT3 est fermé, le condensateur C6 se décharge et la tension VPC augmente :
VPC = K4*IP, avec K4 une constante fonction de R13, R14, R15 et de C6.

Inversement, lorsque PC est inactif, INT3 est ouvert, C6 se charge et la tension VPC diminue :

VPC = -K5*IP, avec K5 une constante fonction de R12, R13, R14 R15 et de C6.

Dans un exemple, on pourra choisir R12, R13, R14 R15 et C6 de sorte que K4 = 2*K5.

La bascule RS est réalisée selon un schéma connu, qui comprend deux comparateurs, pour comparer la tension VPC avec les potentiels de référence -E0 et +E0, et deux portes logiques de type NON-OU conformément à la figure 6. Le signal PC est produit sur une sortie de l'une des portes logiques.

Du fait de la bascule 630, la tension VPC produite par le générateur 610 est bornée entre -E0 et +E0, elle est par ailleurs croissante ou décroissante selon des pentes constantes. La tension VPC est donc une tension triangulaire et périodique.

La durée d'une phase croissante de VPC est égale à T4 = 2*E0/(K4*IP) et la durée d'une phase décroissante de VPC est égale à T5 = 2*E0/(K5*IP). On en déduit finalement que la fréquence FPC de VPC, égale à 1/(T4 + T5) est directement proportionnelle à IP.

Le signal PC obtenu en sortie de la bascule 630 est quant à lui un signal logique en créneau, dont la fréquence est directement proportionnelle à la valeur du courant IP appliqué à l'entrée E1 du circuit 610.

On a finalement :

```
FPC = K6 * IP
    = (K6 * K3/(2E0)) * U * (E0 - K1 *<I(t)>,
```

avec

K6, une constante fixée par le générateur de tension 610 (fonction dans l'exemple de K4, K5),

K3, une constante fixée par le circuit d'adaptation 420 et le circuit d'intégration 430 (fonction dans l'exemple du condensateur C5 et des résistances R6, R11),

K1, une constante fixée par le mesureur de courant 110 et l'intégrateur 402 du circuit de calcul. La valeur de K1 peut être adaptée par le circuit d'adaptation 404,

U, la tension appliquée sur la lignée étudiée et <I(t)> la valeur moyenne du courant instantané consommé.

Le signal PC est finalement le signal produit par le compteur selon l'invention. La fréquence FPC du signal PC est donc bien proportionnelle à la puissance consommée (U * <I(t)>).

A noter que dans les exemples décrits, le coefficient de proportionnalité entre la fréquence FPC et la puissance consommée est négatif. Pour obtenir un coefficient de proportionnalité positif, il suffit d'inverser le signal PM en sortie du circuit d'adaptation 420, et de calculer le courant IP à partir du signal PM inversé.

Les modes de réalisation d'un compteur tels que décrits ci-dessus en relation avec les figures 2 à 6 ne sont que des exemples. Des améliorations et / ou des variantes des modes de réalisation décrits ci-dessus peuvent être envisagés.

Une première amélioration a pour but de protéger le compteur contre la dérive éventuelle de certains composants dans le temps.

Par exemple, dans les modes de réalisation décrits, on utilise souvent des intégrateurs comprenant notamment (figure 7a) une résistance R connectée à une entrée négative d'un amplificateur AO, un condensateur C connecté entre l'entrée négative et une sortie de l'amplificateur AO dont une entrée positive est connectée à la masse. Une autre borne de la résistance R constitue l'entrée de l'intégrateur et la sortie de l'amplificateur AO forme la sortie de l'intégrateur. Un tel intégrateur a une constante de temps TX égale au produit R*C.

A l'usage, la constante de temps TX risque de varier, car les résistances et les condensateurs d'un même circuit intégré vieillissent à l'usage, et vieillissent de manière différente dans le temps.

La modification d'une constante de temps TX utilisée dans un compteur selon l'invention va entraîner des erreurs dans le calcul de la puissance consommée sur la ligne électrique étudiée, ce qui est évidemment dommageable aussi bien pour le fournisseur d'énergie que pour le consommateur.

Pour résoudre ce problème, il est possible de remplacer certaines résistances du compteur de l'invention (notamment celles appartenant à un ensemble intégrateur) par une capacité dite capacité commutée CC, telle que représentée sur la figure 7b.

Le circuit CC (figure 7b) comprend deux interrupteurs commandés INT5, INT6, un condensateur C11 et un inverseur I1.

Les interrupteurs sont associés en série et un point commun des interrupteurs INT5, INT6 est connecté à un pôle d'un condensateur C11 dont l'autre pôle est connecté à une masse du circuit. Un signal d'horloge CL est appliqué d'une part sur une entrée de commande de l'interrupteur INT5 par l'intermédiaire de l'inverseur I1 et d'autre part sur l'entrée de commande de l'interrupteur INT6. Lorsque le signal CL est actif, l'interrupteur INT5 est ouvert et l'interrupteur INT6 est fermé. Inversement, lorsque le signal CL et inactif, INT5 est fermé et INT6 est ouvert. Le signal d'horloge CL est choisi avec une fréquence élevée. Pour le compteur on peut utiliser par exemple le signal CK produit par le diviseur de fréquence 220 du générateur 200 de signaux triangulaires (si le compteur est réalisé avec un générateur tel que celui de la figure 2) ou bien tout autre signal d'horloge disponible et de fréquence suffisamment élevée.

On montre que le circuit CC est équivalent à une résistance de valeur REQ = F*C11, F étant la fréquence du signal d'horloge CL commandant les interrupteurs du circuit CC.

Le circuit CC, le condensateur C10 et l'amplificateur AO associés selon le schéma de la figure 7b forment alors ensemble un intégrateur de constante de temps égale à TX = F*C11 / C10.

TX est fonction de la fréquence du signal d'horloge CL. Il est donc aisé de modifier la constante de temps TX en variant la fréquence F du signal CL.

Par ailleurs, TX dépend également du rapport C11/C10 qui a l'avantage de ne pas dériver à l'usage, au cours du temps, contrairement à un produit R*C. En effet, deux condensateurs sur un même circuit intégré vieillissent de manière similaire à l'usage et la valeur de leur capacité varie de la même manière. Le rapport de leur capacité reste donc constant au cours du temps.

Le compteur tel que décrit en relation avec les figures 1 à 6 permet de mesurer la consommation de puissance sur une ligne électrique monophasée.

Une autre amélioration permet d'utiliser le compteur selon l'invention dans le cas où la ligne dont on souhaite mesurer la puissance consommée est une ligne triphasée.

Pour cela, on ajoute simplement, pour chaque phase, un mesureur de courant, un mesureur de tension, un circuit d'entrée et un circuit d'adaptation, réalisés de manière similaire aux circuits 110, 120, 410, 420 des figures 1 à 6 et connectés de manière similaire.

Les sorties respectives de tous les circuits 420 sont finalement connectées ensemble à l'entrée du circuit 430 unique (voir à titre d'exemple le circuit 420' en pointillés figure 4, identique au circuit 420).

Par exemple, dans le cas d'une ligne triphasée, le premier circuit 420 produit un courant PM1 proportionnel à la puissance consommée dans la première phase, le deuxième circuit 420 produit un courant PM2 proportionnel à la puissance consommée dans la deuxième phase, le troisième circuit 420 produit un courant PM3 proportionnel à la puissance consommée dans la troisième phase.

A l'entrée de l'intégrateur 430, les courants PM1, PM2, PM3 s'ajoutent et la somme PM = PM1 + PM2 + PM3 est intégrée par le circuit 430. Le courant IP produit par l'intégrateur 430 est finalement proportionnel à la somme PM, c'est-à-dire à la puissance totale consommée sur la ligne électrique triphasée.

**Revendications**

1. Compteur électrique pour mesurer la puissance consommée sur une ligne électrique, le compteur comprenant un mesureur de courant (110) pour produire un courant image (II(t)) du courant instantané (I(t)) circulant dans la ligne, et un mesureur de tension (120) pour produire une tension image (VT(t)) de la tension instantanée (U(t)) circulant dans la ligne,

   le compteur étant **caractérisé en ce qu'**il comprend :

   - un premier générateur (130) de tension pour produire une tension de référence (VREF) triangulaire de période T, le premier générateur de tension (130) comprenant des moyens pour ajuster la période de la tension de référence (VREF) de sorte à ajuster un calibre de puissance du compteur en fonction de l'amplitude du courant instantané circulant dans la ligne.
   - un circuit de calcul (140) d'une puissance image (IP(t)) de la puissance instantanée consommée sur la ligne, à partir du premier courant image (II(t)), de la tension image (VT(t)) et de la tension de référence (VREF),
   - un convertisseur (150) pour produire un signal numérique de puissance (PC) représentatif de la puissance image (IP(t)).

2. Compteur selon la revendication 1, **caractérisé en ce que** le circuit de calcul (140) comprend :

   - un circuit d'entrée (410) pour produire un courant moyen (VIM) représentatif de la valeur moyenne du courant image (II(t)),
   - un circuit d'adaptation (420) pour produire un signal (PM) en créneaux de période T, actif pendant une durée T0 proportionnelle au courant moyen (VIM), et d'amplitude, lorsqu'il est actif, proportionnelle à la tension image (VT(t)),
   - un premier intégrateur (430), pour intégrer le signal (PM) en créneaux et produire la puissance image(IP(t)).

3. Compteur selon la revendication 2, **caractérisé en ce que** le circuit d'entrée comprend :

   - un deuxième intégrateur (402) pour intégrer le courant image reçu sur une première entrée et produire le courant moyen (VIM) sur une sortie,
   - un circuit de calibrage (404), pour adapter un niveau d'entrée du deuxième intégrateur (402) en fonction du courant moyen (VIM).

4. Compteur selon la revendication 3, **caractérisé en ce que** le circuit de calibrage (404) comprend :

   - un troisième intégrateur (C4, R6, AO5) comprenant une entrée connectée à la sortie du deuxième intégrateur (402), et
   - un pont diviseur de tension (R7, R8) dont une entrée est connectée à une sortie du troisième intégrateur (C4, R6, AO5) et dont une sortie est connectée à une deuxième entrée du deuxième intégrateur (402).

5. Compteur selon la revendication 3, **caractérisé en ce que** le deuxième intégrateur (402) comprend :

   - un premier amplificateur opérationnel (AO4) comprenant une entrée positive connectée à une masse, et une sortie connectée à une sortie du deuxième intégrateur (402) sur laquelle est disponible le courant moyen (VIM), et
   - un premier condensateur (C3) connecté entre une entrée négative et la sortie du premier amplificateur (AO4), l'entrée négative du premier amplificateur (AO4) étant également connectée à la deuxième entrée du deuxième intégrateur (402).

6. Compteur selon la revendication 5, **caractérisé en ce que** le deuxième intégrateur (402) comprend également :

   - une première résistance (R5) connectée entre une entrée négative du premier amplificateur (AO4) et la première entrée de l'intégrateur (402).

7. Compteur selon la revendication 5, **caractérisé en ce qu'**il comprend également une capacité commutée (CC) à deux pôles connectée entre l'entrée négative du premier amplificateur (AO4) et la première entrée de l'intégrateur (402), la capacité commutée (CC) comprenant :

- un premier interrupteur (INT5) et un deuxième interrupteur (INT6) connectés en série entre les deux pôles de la capacité commutée (CC), le premier interrupteur et le deuxième interrupteur étant commandés par des signaux d'horloge (CL, CL') en opposition de phase,
- un deuxième condensateur (C11) connecté entre la masse et un point commun du premier interrupteur (INT5) et du deuxième interrupteur (INT6).

8. Compteur selon l'une des revendications 2 à 7,
   **caractérisé en ce que** le circuit d'adaptation (420) comprend :

   - un comparateur (CO1) comprenant une entrée positive sur laquelle est appliquée la tension de référence (VREF) et une entrée négative sur laquelle est appliquée le courant moyen (VIM), le comparateur (CO1) produisant un signal de commande (SC2),
   - une deuxième résistance (R9) et un troisième interrupteur (INT2) connectés en série entre une entrée (E3) et une sortie du circuit d'adaptation (420) sur laquelle est produit le signal (PM) en créneaux, le troisième interrupteur étant commandé par le signal de commande (SC2), la tension image (VT(t)) étant appliquée l'entrée du circuit d'adaptation (420).

9. Compteur selon l'une des revendications 1 à 8, **caractérisé en ce que** le convertisseur (150) comprend :

   - un deuxième générateur de tension (610) recevant la puissance image (IP(t)) et produisant, en fonction du signal numérique de puissance (PC), une tension triangulaire (VPC) qui est :

   - croissante selon une pente proportionnelle à +IP, si le signal numérique de puissance (PC) est actif, IP étant la puissance image, ou
   - décroissante selon une pente proportionnelle à -IP si le signal numérique de puissance (PC) est inactif,
   - une bascule (630) pour produire le signal numérique de puissance qui est :

   - actif lorsque la tension triangulaire est croissante et inférieure à un premier seuil (+E0), et
   - inactif lorsque la tension triangulaire est décroissante et supérieure à un deuxième seuil (-E0),
        la fréquence du signal numérique de puissance étant représentative de la puissance instantanée consommée.

10. Compteur selon l'une des revendications 2 à 9, **caractérisé en ce que** le circuit de calcul (140) comprend, pour chaque phase de la ligne électrique, un circuit d'entrée et un circuit d'adaptation (420) associés à un mesureur de courtant (110) et un mesureur de tension (120), et **en ce que** les sorties (SI) de tous les circuits d'adaptation sont connectées ensemble à l'entrée du circuit d'intégration (430).

Fig. 1

Fig. 2

Fig. 3b

Fig. 3a

Fig. 5

Fig. 4

Fig. 7a

Fig. 7b

Fig. 6